# EUROPÄISCHE PATENTSCHRIFT

(11) **EP 2 415 333 B1**
(45) Veröffentlichungstag und Bekanntmachung des Hinweises auf die Patenterteilung: **15.05.2013**
(21) Anmeldenummer: 10717472.4
(22) Anmeldetag: 26.03.2010
(51) Int. Cl.: H05K 7/14, H05B 41/00, H05K 7/20

(54) **BETRIEBSMITTEL MIT INTEGRIERTER KÜHLPLATTE**
OPERATING EQUIPMENT HAVING INTEGRATED COOLING PLATE
MOYEN DE FONCTIONNEMENT AVEC PLAQUE DE REFROIDISSEMENT INTÉGRÉE

(30) Priorität: 30.03.2009 AT 19709 U
(43) Veröffentlichungstag der Anmeldung: 08.02.2012
(73) Patentinhaber: Tridonic GmbH & Co KG, 6851 Dornbirn (AT)
(72) Erfinder: HEER, Roger, CH-8753 Mollis (CH)
(74) Vertreter: Barth, Alexander
(86) Internationale Anmeldenummer: PCT/AT2010/000089
(87) Internationale Veröffentlichungsnummer: WO 2010/111721

(56) Entgegenhaltungen:
- EP-A1- 0 481 409
- EP-A1- 1 087 652
- DE-A1- 19 614 988
- US-A- 5 762 509
- US-A- 5 796 593
- US-A1- 2002 142 632
- US-A1- 2004 190 277
- US-A1- 2004 222 752

## Beschreibung

Die Erfindung betrifft ein Betriebsgerät für ein Leuchtmittel gemäß Patentanspruch 1 und ein Verfahren zur vereinfachten Montage eines Betriebsgeräts für ein Leuchtmittel gemäß Patentanspruch 6.

### Technisches Gebiet

Derartige Betriebsgerät werden in Beleuchtungssystemen verwendet, um eine Beleuchtung von Räumen, Wegen oder auch Fluchtwegen zu erreichen. Üblicherweise werden dabei die Leuchtmittel von Betriebsgeräten angesteuert und bei Bedarf aktiviert. Für eine derartige Beleuchtung werden Gasentladungslampen oder auch Leuchtdioden (LED) als Lichtquelle genutzt. Derartige Betriebsgeräte sind aus der EP 1 087 652 A1 oder der DE 196 14 988 A1 bekannt.

### Stand der Technik

Gemäß dem Stand der Technik wird eine Leiterplatte mit einem integrierten Kühlblech in ein Gehäuse eingesetzt. Dabei handelt es sich um eine mehrschichtige Leiterplatte, bei der zumindest eine Schicht eine gute Wärmeleitfähigkeit aufweist.

### Darstellung der Erfindung

Es ist gemäß dem Stand der Technik nicht möglich, das Kühlblech direkt und auf einfache Weise mit der Leiterplatte zu verbinden, ohne dass ein Einbau in ein Gehäuse erfolgt oder aber die Fertigung einer Leiterplatte mit einem integrierten Kühlblech ist sehr aufwändig.

Es ist die Aufgabe der Erfindung, ein Betriebsgerät für ein Leuchtmittel bereitzustellen, mit mindestens einer Leiterplatte, mindestens einer Bodenplatte mit guter Wärmeleitfähigkeit, die Halteelemente aufweist, wobei die Leiterplatte Öffnungen aufweist, in die Halteelemente eingeführt werden und über die die Bodenplatte mit der Leiterplatte verbunden ist.

Diese Aufgabe wird für eine gattungsgemäße Vorrichtung erfindungsgemäß durch die kennzeichnenden Merkmale des Patentanspruchs 1 und für ein Verfahren erfindungsgemäß durch die kennzeichnenden Merkmale des Patentanspruchs 6 gelöst. Besonders vorteilhafte Ausführungen der Erfindung sind in den Unteransprüchen beschrieben.

Auf diese Weise ist es möglich, ein Betriebsgerät für ein Leuchtmittel mit einer Leiterplatte und einer Bodenplatte bereitzustellen, das auf einfache Weise montiert werden kann.

### Beschreibung der bevorzugten Ausführungsbeispiele

Nachfolgend soll die Erfindung anhand der beigefügten Zeichnung näher erläutert werden. Es zeigen:
Fig. 1 zeigt eine erste Ausgestaltung einer Bodenplatte für ein erfindungsgemäßes Betriebsgerät
Fig. 2 und Fig. 4 zeigen Ausgestaltungen des Aufbaus eines erfindungsgemäßen Betriebsgeräts
Fig. 3 zeigt einen Ausschnitt einer Bodenplatte mit einem Halteelement für ein erfindungsgemäßes Betriebsgerät

Nachfolgend wird die Erfindung anhand eines Ausführungsbeispiels eines Betriebsgerätes für ein Leuchtmittel erklärt.

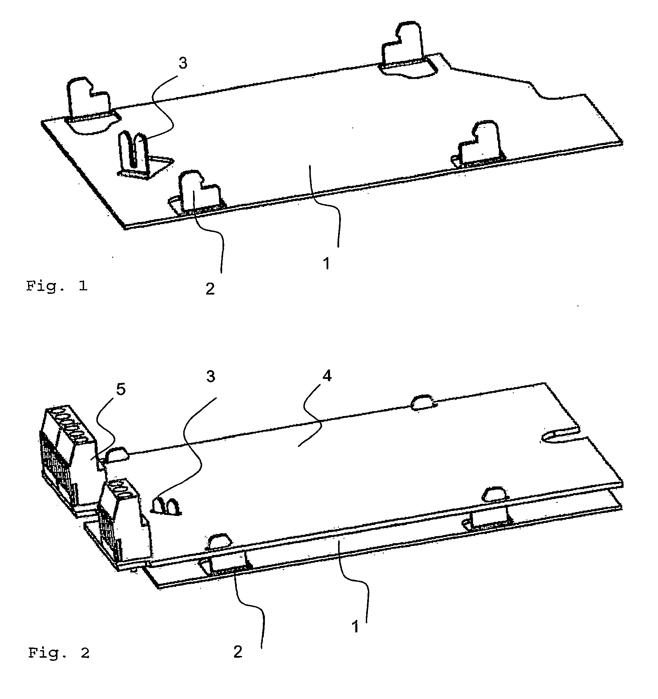

In der Fig. 1 ist eine Ansicht einer Bodenplatte 1 dargestellt. Die Bodenplatte 1 weist vorzugsweise eine gute Wärmeleitfähigkeit auf. Sie kann mehrere Halteelemente 2 aufweisen und eine Kontaktzunge 3 aufweisen.

Die Halteelemente 2 werden vorzugsweise aus der Bodenplatte 1 ausgestanzt und gebogen. Auch die Kontaktzunge 3 kann aus der Bodenplatte 1 ausgestanzt und gebogen werden. Die Kontaktzunge 3 kann auch einzeln gefertigt worden und mit der Bodenplatte 1 verbunden sein, beispielsweise über eine Nietverbindung.

In der Fig. 2 ist der schematische Aufbau eines Betriebsgerätes A für ein Leuchtmittel gezeigt. Das Betriebsgerät A für ein Leuchtmittel weist mindestens eine Leiterplatte 4 und mindestens eine Bodenplatte 1 mit guter Wärmeleitfähigkeit auf. Die Bodenplatte 1 weist dabei die Halteelemente 2 auf. Die Leiterplatte 4 weist Öffnungen 7 auf, in die Halteelemente eingeführt werden und über die die Bodenplatte 1 mit der Leiterplatte 4 verbunden ist.

Die Bodenplatte 1 kann elektrisch leitend sein und eine Kontaktzunge 3 aufweisen, die durch eine weitere Öffnung 8 der Leiterplatte 4 geführt und mittels einer Leiterbrücke auf der Leiterplatte 4 kontaktiert wird. Es wird also die Bodenplatte 1 mittels der Kontaktzunge 3 und der Leiterbrücke mit der Leiterplatte 4 elektrisch kontaktiert.

Die Halteelemente 2 können widerhakenförmig ausgebildet sein.

Die Verbindung der Leiterplatte 4 mit der Bodenplatte 1 kann über ein Aufsetzen unter Druck erfolgen, so dass die widerhakenförmigen Halteelemente 2 in die Öffnungen 7 eingerastet werden.

Die Öffnungen 7 sind vorzugsweise am Rand der Leiterplatte vorgesehen. Die Öffnungen 7 (und auch die weitere Öffnung 8) sind vorzugsweise als Schlitz ausgeformt, in die widerhakenförmigen Halteelemente 2 in die Öffnungen 7 eingerastet werden können.

Die Leiterplatte 4 kann zumindest einen Klemmenblock 5 zur Kontaktierung oder auch eine andere Möglichkeit zur Kontaktierung wie beispielsweise direkt angeschlossene Drähte aufweisen.

Die Leiterplatte 4 kann über die Kontaktzunge 3 mit zumindest einer Klemme des Klemmenblocks 5 elektrisch verbunden werden, indem die Kontaktzunge 3 durch eine weitere Öffnung 8 der Leiterplatte 4 geführt und mit einer Leiterbrücke auf der Leiterplatte 4 kontaktiert wird. Die Leiterbrücke kann als nicht-isoliertes Drahtstück auf der Leiterplatte 4 aufgebracht und mit dieser kontaktiert sein.

Das Betriebsgerät A kann ein Gehäuseoberteil, vorzugsweise aus Kunststoff, aufweisen. Das Betriebsgerät A kann weiterhin ein Gehäuseunterteil, vorzugsweise aus Kunststoff, aufweisen.

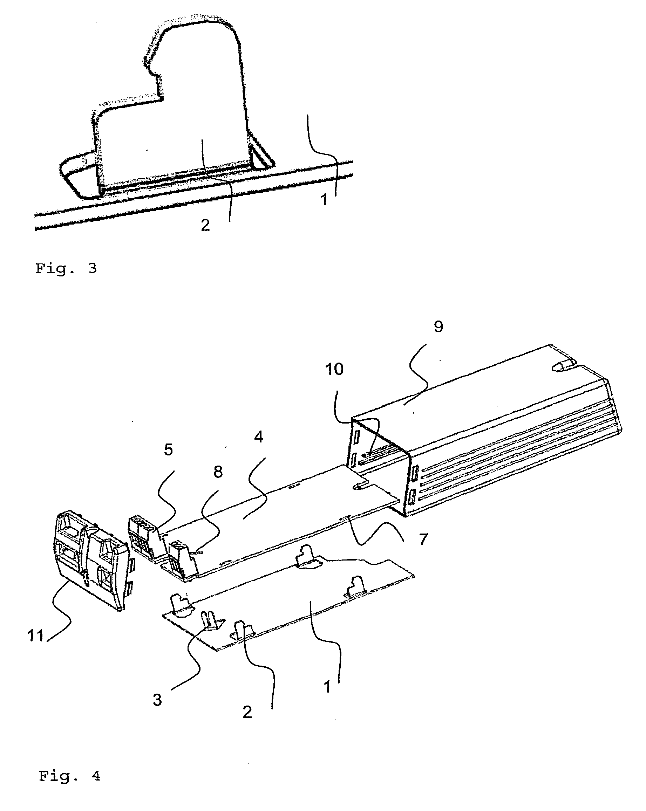

Es kann aber auch die Bodenplatte 1 das Unterteil des Betriebsgerätes A bilden. Es ist aber auch möglich, dass wie in Fig. 4 dargestellt, das Gehäuseoberteil und das Gehäuseunterteil als ein einstückiges Gehäuseteil 9 ausgebildet sind. Das Gehäuseteil 9 kann Führungen 10 für die Leiterplatte 1 oder auch die Bodenplatte 4 aufweisen, die eine Aufnahme und Halterung für diese bilden. Das Gehäuse mit dem Gehäuseteil 9 kann weiterhin eine Endkappe 11 aufweisen, welches eine Seitenfläche des Gehäuseteils 9 verschließt.

Beispielsweise kann so eine Beleuchtungseinheit mit mindestens einem Betriebsgerät A für ein Leuchtmittel aufgebaut werden, welches eine sehr gute thermische Performance (Verhalten) aufweist.

Somit wird ein Verfahren zur vereinfachten Montage eines Betriebsgerätes A für ein Leuchtmittel ermöglicht, mit einer Leiterplatte 4, die Öffnungen 7 aufweist, mit einer Bodenplatte 1, die widerhakenförmige Halteelemente 2 aufweist, wobei die Verbindung der Leiterplatte 4 mit der Bodenplatte 1 durch ein Aufsetzen unter Druck erfolgt, so dass die widerhakenförmigen Halteelemente 2 in die Öffnungen 7 einrasten.

Gleichzeitig kann die Leiterplatte 4 über eine Kontaktzunge 3, welche sich auf der Bodenplatte 1 befindet, elektrisch mit der Bodenplatte 1 kontaktiert werden.

## Patentansprüche

1. Betriebsgerät (A) für ein Leuchtmittel mit
- mindestens einer Leiterplatte (4),
- mindestens einer Bodenplatte (1) mit guter Wärmeleitfähigkeit, die Halteelemente (2) aufweist, wobei die Leiterplatte (4) Öffnungen aufweist, in die Halteelemente (2) eingeführt werden und über die die Bodenplatte (1) mit der Leiterplatte (4) verbunden ist,
wobei die Bodenplatte (1) elektrisch leitend ist und eine Kontaktzunge (3) aufweist, die durch eine weitere Öffnung der Leiterplatte (4) geführt und mit einer Leiterbrücke auf der Leiterplatte (4) kontaktiert wird,
**dadurch gekennzeichnet,**
**daß** die Halteelemente (2) widerhakenförmig ausgebildet sind,
**daß** die Halteelemente (2) und die Kontaktzunge (3) aus der Bodenplatte (1) ausgestanzt und gebogen werden, daß die Verbindung der Leiterplatte (4) mit der Bodenplatte (1) über ein Aufsetzen unter Druck erfolgt, so dass die widerhakenförmigen Halteelemente (2) in die Öffnungen eingerastet werden, und gleichzeitig die Leiterplatte (4) über die Kontaktzunge (3) elektrisch mit der Bodenplatte (1) kontaktiert wird.

2. Betriebsgerät (A) für ein Leuchtmittel nach Anspruch 1, **dadurch gekennzeichnet,**
**daß** die Leiterplatte (4) zumindest einen Klemmenblock (5) zur Kontaktierung aufweist.

3. Betriebsgerät (A) für ein Leuchtmittel nach Anspruch 2,
**dadurch gekennzeichnet,**
**daß** die Leiterplatte (4) über die Kontaktzunge (3), die durch eine Öffnung der Leiterplatte (4) geführt und mit einer Leiterbrücke auf der Leiterplatte (4) kontaktiert wird, mit zumindest einer Klemme des Klemmenblocks (5) elektrisch verbunden wird.

4. Betriebsgerät (A) für ein Leuchtmittel nach einem der Ansprüche 1 bis 2, **dadurch gekennzeichnet,**
**daß** das Betriebsgerät (A) ein Gehäuseoberteil, vorzugsweise aus Kunststoff, aufweist.

5. Beleuchtungseinheit aufweisend ein Betriebsgerät (A) für ein Leuchtmittel nach einem der Ansprüche - bis 3.

6. Verfahren zur vereinfachten Montage eines Betriebsgerätes (A) für ein Leuchtmittel mit einer Leiterplatte (4), die Öffnungen aufweist, mit einer Bodenplatte (1) mit guter Wärmeleitfähigkeit, die widerhakenförmige Halteelemente (2) aufweist,
wobei die Bodenplatte (1) elektrisch leitend ist und eine Kontaktzunge (3) aufweist, die durch eine weitere Öffnung der Leiterplatte (4) geführt und mit einer Leiterbrücke auf der Leiterplatte (4) kontaktiert wird, wobei die Halteelemente (2) und die Kontaktzunge (3) aus der Bodenplatte (1) ausgestanzt und gebogen werden,
wobei die Verbindung der Leiterplatte (4) mit der Bodenplatte (1) durch ein Aufsetzen unter Druck erfolgt, so dass die widerhakenförmigen Halteelemente (2) in die Öffnungen einrasten und gleichzeitig die Leiterplatte (4) über die Kontaktzunge (3) elektrisch mit der Bodenplatte (1) kontaktiert wird.

## Claims

1. Operating device (A) for a light-emitting means having
- at least one printed circuit board (4),
- at least one base plate (1) with good thermal conductivity which has holding elements (2),
wherein the printed circuit board (4) has openings, into which holding elements (2) are inserted and via which the base plate (1) is connected to the printed circuit board (4), wherein the base plate (1) is electrically conductive and has a contact tongue (3), which is guided through a further opening in the printed circuit board (4) and is brought into contact with a conductor link on the printed circuit board (4), **characterized in that** the holding elements (2) are in the form of barbs, **in that** the holding elements (2) and the contact tongue (3) are stamped out of the base plate (1) and bent, **in that** the connection between the printed circuit board (4) and the base plate (1) is made by virtue of pressure being applied, with the result that the barb-shaped holding elements (2) are latched into the openings and, at the same time, the printed circuit board (4) is brought into electrical contact with the base plate (1) via the contact tongue (3) .

2. Operating device (A) for a light-emitting means according to Claim 1, **characterized in that** the printed circuit board (4) has at least one terminal block (5) for contact-making.

3. Operating device (A) for a light-emitting means according to Claim 2, **characterized in that** the printed circuit board (4) is electrically connected to at least one terminal of the terminal block (5) via the contact tongue (3), which is guided through an opening in the printed circuit board (4) and is brought into contact with a conductor link on the printed circuit board (4).

4. Operating device (A) for a light-emitting means according to either of Claims 1 to 2, **characterized in that** the operating device (A) has a housing upper part, preferably consisting of plastics.

5. Lighting unit having an operating device (A) for a light-emitting means according to one of Claims 1 to 3.

6. Method for simplified installation of an operating device (A) for a light-emitting means having a printed circuit board (4), which has openings, having a base plate (1) with good thermal conductivity which has barb-shaped holding elements (2), wherein the base plate (1) is electrically conductive and has a contact tongue (3), which is guided through a further opening in the printed circuit board (4) and is brought into contact with a conductor link on the printed circuit board (4), wherein the holding elements (2) and the contact tongue (3) are stamped out of the base plate (1) and bent, wherein the connection between the printed circuit board (4) and the base plate (1) is made by virtue of pressure being applied, with the result that the barb-shaped holding elements (2) latch into the openings and, at the same time, the printed circuit board (4) is brought into electrical contact with the base plate (1) via the contact tongue (3).

## Revendications

1. Appareil de commande (A) pour un moyen d'éclairage, comprenant
- au moins un circuit imprimé (4),
- au moins une plaque de base (1) possédant une bonne conductivité thermique, laquelle présente des éléments de maintien (2),
le circuit imprimé (4) présentant des ouvertures dans lesquelles sont insérés les éléments de maintien (2) et
par le biais desquelles la plaque de base (1) est reliée avec le circuit imprimé (4),
la plaque de base (1) étant électriquement conductrice et présentant une languette de contact (3) qui passe à travers une ouverture supplémentaire du circuit imprimé (4) et qui est mise en contact sur le circuit imprimé (4) avec un cavalier conducteur,
**caractérisé en ce**
**que** les éléments de maintien (2) sont réalisés en forme d'ardillons,
**que** les éléments de maintien (2) et la languette de contact (3) sont découpés à la matrice dans la plaque de base (1) et pliés,
**que** l'assemblage du circuit imprimé (4) avec la plaque de base (1) s'effectue par une pose sous pression, de sorte que les éléments de maintien (2) en forme d'ardillons sont enclipsés dans les ouvertures et, simultanément, le circuit imprimé (4) est mis en contact électrique avec la plaque de base (1) par le biais de la languette de contact (3).

2. Appareil de commande (A) pour un moyen d'éclairage selon la revendication 1, **caractérisé en ce que** le circuit imprimé (4) présente au moins un bornier (5) pour la mise en contact.

3. Appareil de commande (A) pour un moyen d'éclairage selon la revendication 2, **caractérisé en ce que** le circuit imprimé (4) est relié électriquement avec au moins une borne du bornier (5) par le biais de la languette de contact (3) qui est insérée à travers une ouverture du circuit imprimé (4) et mise en contact avec un cavalier conducteur sur le circuit imprimé (4).

4. Appareil de commande (A) pour un moyen d'éclairage selon l'une des revendications 1 ou 2, **caractérisé en ce que** l'appareil de commande (A) présente une partie supérieure de boîtier, de préférence en matière plastique.

5. Unité d'éclairage présentant un appareil de commande (A) pour un moyen d'éclairage selon l'une des revendications 1 à 3.

6. Procédé de montage simplifié d'un appareil de commande (A) pour un moyen d' éclairage comprenant un circuit imprimé (4), lequel présente des ouvertures, comprenant une plaque de base (1) possédant une bonne conductivité thermique, laquelle présente des éléments de maintien (2) en forme d'ardillons,
la plaque de base (1) étant électriquement conductrice et présentant une languette de contact (3) qui passe à travers une ouverture supplémentaire du circuit imprimé (4) et qui est mise en contact sur le circuit imprimé (4) avec un cavalier conducteur,
les éléments de maintien (2) et la languette de contact (3) étant découpés à la matrice dans la plaque de base (1) et pliés,
l'assemblage du circuit imprimé (4) avec la plaque de base (1) s'effectuant par une pose sous pression, de sorte que les éléments de maintien (2) en forme d'ardillons sont enclipsés dans les ouvertures et, simultanément, le circuit imprimé (4) est mis en contact électrique avec la plaque de base (1) par le biais de la languette de contact (3).
